# EUROPEAN PATENT APPLICATION

(11) **EP 4 723 823 A1**
(43) Date of publication of application: **08.04.2026**
(21) Application number: 25203886.4
(22) Date of filing: 23.09.2025
(51) Int. Cl.: H10B 12/00, H10D 1/68

(54) **SYSTEM AND METHODS FOR A NESTED CAPACITOR**

(30) Priority: 01.10.2024 US 202463702143 P; 20.06.2025 US 202519245247
(71) Applicant: SAMSUNG ELECTRONICS CO., LTD., Yeongtong-gu Suwon-si, Gyeonggi-do 16677 (KR)
(72) Inventor: AHN, Kwangho, San Jose, CA, 95134 (US); KIM, Dongwan, San Jose, CA, 95134 (US); LEE, Don Koun, San Jose, CA, 95134 (US)
(74) Representative: Kuhnen & Wacker Patent- und Rechtsanwaltsbüro PartG mbB

(57) **Abstract**

Disclosed herein are methods, devices and systems including a first capacitor with a first electrode with a first segment and a second segment extending from a proximal end to a distal end in a first direction and joined at the proximal end by a connecting segment to form a mouth. A second electrode may have a third segment, a fourth segment, and a fifth segment, which form a fork facing the first electrode in the first direction. The fork may have a first slot enclosing the first segment between the third and fourth segments, and a second slot enclosing the second segment between the fourth and fifth segments. A first semiconductor channel may be on a side of the first electrode opposite the second electrode, with the first semiconductor having a first nub end extending in the first direction into the mouth at the proximal end. An intermediate dielectric layer may be between the first electrode and the second electrode, extending alongside the third, fourth, and fifth segment in the first and the second slot.

## Description

### TECHNICAL FIELD

The subject matter disclosed herein relates to microelectronics and integrated circuits (IC) structures. More particularly, the subject matter disclosed herein relates to a semiconductor structure involving a capacitor structure for a three-dimensional circuit.

### BACKGROUND

Semiconductor devices may be created using complex three-dimensional (3D) structures made up of sets of smaller components. Such components may include circuit components, such as transistors, capacitors, etc., reproduced in large numbers and addressed using a matrix of intersecting lines. However, forming components in 3-D structures faces a number of challenges. For example, to increase capacity in vertically stacked dynamic random-access memory (VSDRAM), the area of the embedded capacitor needs to be increased. This may present challenges in the fabrication process.

It is further noted that background concepts discussed herein are for informational purposes only and are not intended to limit the present disclosure, nor should the background or field described be intended to limit the disclosure herein to a particular use or concept.

### SUMMARY

An example embodiment provides a device with a first capacitor with a first electrode and a second electrode. The first electrode may have a first segment and a second segment extending from a proximal end to a distal end in a first direction and joined at the proximal end by a connecting segment to form a mouth. The second electrode may have a third segment, a fourth segment, and a fifth segment, which join together to form a fork facing the first electrode in the first direction. The fork may have a first slot enclosing the first segment between the third and fourth segments, and a second slot enclosing the second segment between the fourth and fifth segments. A first semiconductor channel may be arranged on a side of the first electrode opposite the second electrode, with the first semiconductor having a first nub end and extending in the first direction into the mouth at the proximal end. An intermediate dielectric layer may be arranged between the first electrode and the second electrode, extending alongside the third segment, the fourth segment and the fifth segment in the first slot and the second slot. The first electrode may have a first open cylinder shape extending to form a U-shaped cross-section and the second electrode may have a second open cylinder shape and a W-shaped cross-section. A second semiconductor channel may have a second nub end and extend in the first direction above the first semiconductor channel into a second capacitor having a structure similar to the first capacitor. The first nub end and the second nub end may be aligned in a second direction orthogonal to the first direction. The intermediate dielectric layer may include a material having a higher dielectric constant than silicon oxide. The intermediate dielectric layer may conformally enclose the first electrode, and the second electrode may conformally enclose the intermediate dielectric layer. The second electrode may concentrically enclose the first electrode. The first electrode may be coupled to a source, the second electrode may be coupled to a drain, while a transistor may be between the first electrode and the source, with the first electrode, the second electrode and the transistor forming a memory cell.

An example embodiment provides a device with a first electrode forming a first capacitive structure, a second electrode forming a second capacitive structure, and a first dielectric material arranged between the first capacitive structure and the second capacitive structure. The first capacitive structure may contact a first semiconductor on a first side and have an axial opening. The second capacitive structure may have a central prong coupled to an exterior section, with the central prong extending within the axial opening of the first capacitive structure. The first dielectric material may be located on a second side of the first capacitive structure, the second side opposite the first side. The first capacitive structure and the second capacitive structure may be coaxial. The first dielectric material may have a higher dielectric constant than silicon oxide. The first dielectric material may conformally coat the first electrode and the second electrode may conformally coat the first dielectric material. The exterior section of the second capacitive structure may form a cylindrical shape. A third electrode may form a third capacitive structure with the second electrode forming a fourth capacitive structure arranged coaxially with the third capacitive structure and the first dielectric material may be arranged between the third capacitive structure and the fourth capacitive structure. The first capacitive structure and the second capacitive structure may form a capacitor within a memory cell of a vertically-stacked dynamic random-access memory.

An example embodiment provides a method including forming a mold within a first dielectric, depositing a first conductor within the mold to conformally coat the mold, forming the first conductor into one or more first electrodes, forming an intermediate dielectric over the one or more first electrodes, and depositing a second conductor over the intermediate electrode to form one or more second electrodes. The one or more first electrodes may be separated by the first dielectric, and the one or more second electrodes may form a continuous layer. The first dielectric may include one or more of a carbide, nitride or oxide, and the intermediate dielectric may include a material with a higher dielectric constant than silicon oxide. The second conductor may be deposited by a conformal process, and the intermediate dielectric may be deposited by a conformal process. A plate conductor may be deposited over the second conductor after the second conductor is deposited. The first conductor may be formed into the one or more first electrodes by removing portions of the first conductor between each of the one or more first electrodes. The mold within the first dielectric may be formed in a direction parallel to a planar surface of a substrate supporting the first electrode. The intermediate dielectric may form a contiguous layer between the one or more first electrodes and the one or more second electrodes.

### BRIEF DESCRIPTION OF THE DRAWING

In the following section, the aspects of the subject matter disclosed herein will be described with reference to example embodiments illustrated in the figures, in which:
FIG. 1 depicts a cross-sectional view of a semiconductor structure according to various embodiments of the subject matter disclosed herein;
FIG. 2 depicts a perspective cross-section view of a semiconductor structure according to various embodiments of the subject matter disclosed herein;
FIG. 3 depicts a circuit structure according to various embodiments of the subject matter disclosed herein;
FIG. 4 depicts a flowchart of a method of forming a semiconductor structure according to various embodiments of the subject matter disclosed herein;
FIGS. 5-24 depict various views of an example embodiment of a semiconductor structure at different stages of its manufacture; and
FIG. 25 is a diagram illustrating a device including simplified parts of three capacitors according to one embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms, and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms, and a plural term may include the corresponding singular form. It is further noted that various figures (including component diagrams) shown and discussed herein are for illustrative purpose only and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

The term "surround" (as in "a first object surrounds a second object") as used herein describes the first object enclosing or is formed around or over the second object, or the first object accommodates, conforms, follows, aligns, or follows the path of the second object.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Disclosed herein are various embodiments of devices, systems and methods related to a nested capacitor within a 3D memory device. The disclosed fabrication technique provides several advantages. First, the surface area of the capacitor may be made large to increase capacitance, which in turn leads to higher memory density. Second, the increased surface area may be achieved by forming the capacitor having a cylindrical shape. A cylindrical solid shape is suitable for a vertical 3D structure like VSDRAM. Third, the dimensions of the components of the capacitor such as the electrodes may be controlled with accuracy. This may be achieved by performing recess of the transistor channel after the oxide recess. A constant transistor channel length leads to a constant electrode length in the capacitor. A 3D memory device may have an array of memory cells including a transistor and a pair of electrodes spaced apart by a dielectric material, the pair of electrodes forming a capacitor. The pair of electrodes may be referred to as a bottom electrode and a top electrode. The bottom electrode may receive an electrical signal via a source side vertical electrode, also known as the bit line, which a transistor modulates via a horizontal electrode also known as the write line. A plurality of memory cells may be arranged in the array stacked vertically in columns to share the same vertical electrode, and horizontally laid out in rows to share the same write electrode.

The bottom electrode may be coupled to the semiconductor material of the transistor channel at an end of the transistor channel. The transistor channel may be formed from a semiconductor material, and a first dielectric material and a second dielectric material may surround the portion of the transistor channel within the transistor. The bottom electrode may be formed from a conductive material and may form a cap over the end of the transistor channel. The bottom electrode may extend outward from the cap to form a cylindrical conductive structure, which may resemble a pair of fins in cross-sectional view. Multiple bottom electrodes may be individually formed to form an array of capacitors corresponding to an array of transistors. The individual bottom electrodes may be separated by one or more dielectric materials between each set of bottom electrodes in between both each row and each column of devices. Over each bottom electrode, an intermediate dielectric is formed conformally such that the same layer may stretch continuously over each bottom electrode in the same portion of the array and form a contiguous layer. The intermediate dielectric may be formed from a high-k dielectric material. A top electrode is formed on top of the intermediate dielectric material and forms a second layer of conductive material. The top electrode may also be formed conformally, such that the top electrode of each cell may contact the top electrode of every other cell in the same portion of the array. The top electrode may also have a cylindrical outer shape, and be concentrically formed around the bottom electrode, forming a nested capacitor structure. The top electrode may thus be coaxially arranged around the bottom electrode. A bulk metal layer may fill in any space between each nested capacitor and form a drain plate.

The nested capacitor structure may be formed by first preparing a molding structure with a first capacitor dielectric and second capacitor dielectric surrounding an extension of the transistor channel. The first capacitor dielectric, made of a first dielectric material, and the second capacitor dielectric, made of a second dielectric material, may be recessed to expose the extension of the transistor channel and the second dielectric material protecting the transistor. The second dielectric material may function as a self-aligned etch stop and may allow for consistent sizing of the nested capacitors and the length of the transistor channel. A first spacer dielectric, made of a first dielectric material, and a second spacer dielectric, made of a second dielectric material, may be formed in conformal layers over the extension of the transistor channel. A first cap dielectric, made of a first dielectric material, may be formed over the spacer dielectrics, before being partially recessed to expose portions of the spacer dielectrics. A second cap dielectric, made of a second dielectric material, may be formed over the first cap dielectric and the spacer dielectrics. The second cap dielectric may be trimmed back to expose the spacer dielectrics on the end of the semiconductor extension and the first cap dielectric. A portion of the second cap dielectric may remain over the first cap dielectric to protect the first cap dielectric from recessing and provide a consistent sized location for forming the nested capacitors. The first spacer dielectric may be partially recessed to expose the extension of the transistor channel. The extension of the transistor channel may be partially removed, leaving a nub which the remains of the first spacer dielectric may contact. By recessing the first spacer dielectric before the transistor channel, the size of the nub may be more easily controlled, and the remains of the first spacer dielectric may prevent over etching of the transistor channel. The remainder of the first spacer dielectric may be further recessed to expose portions of the nub of the transistor channel and may leave a liner layer in contact with the second dielectric material. A first conductive layer, made of a conductive material such as a metal, may be formed conformably over the exposed surfaces including the nub of the transistor channel and second cap dielectric, and the second cap dielectric may form a mold for the shape of the first conductive layer. A third cap dielectric, which may be made of a first dielectric material, may be formed over the first conductive layer and between the first cap dielectric and second cap dielectric. A partial recess may separate the first conductive layer into one or more bottom electrodes. The second cap dielectric may be removed, followed by the removal of the first cap dielectric and the third cap dielectric. The first cap dielectric and the third cap dielectric may be made of the first dielectric. The second spacer dielectric may also be removed, leaving only the bottom electrodes and the liner layer exposed. A high-k dielectric layer may be conformally formed over the bottom electrodes and liner layer to form the intermediate dielectric. A second conductive layer may be formed conformally over the intermediate dielectric to form the top electrodes. A bulk metal layer may fill in any remaining space to form the plate electrode which may act as the drain.

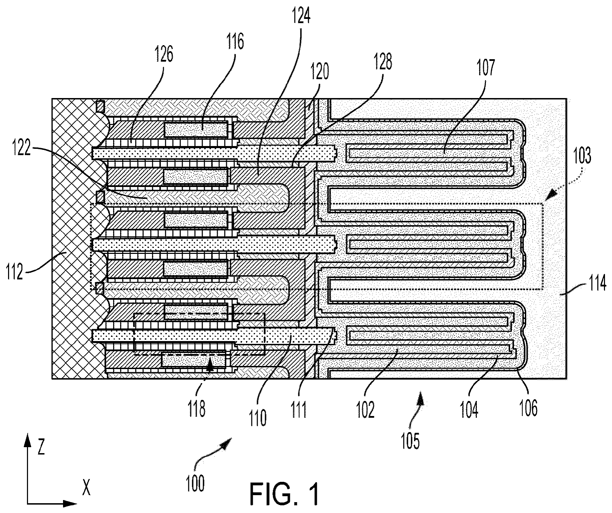

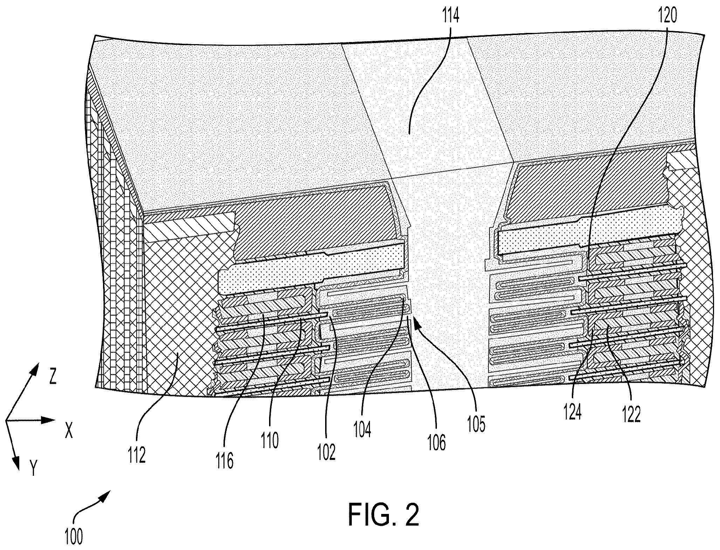

FIG. 1 depicts a cross-sectional view of an example embodiment of a first device architecture 100. FIG. 2 depicts a perspective view of an example embodiment of a first device architecture 100. The first device architecture 100 may form a portion of a 3D memory device, as well as any other suitable three-dimensional semiconductor devices. In the example of FIG. 1, the 3D memory device may take the form of a vertically stacked device, where one or more memory cells 103 may be stacked upon each other. In some embodiments, the one or more memory cells 103 may take the form of a memory device such as dynamic random-access memory (DRAM), with the resulting 3D memory device of the first device architecture 100 taking the form of a vertically stacked DRAM. However, in other embodiments, the form of the one or more memory cells 103 may vary, and may include one or more layers such as static random-access memory (SRAM), synchronous dynamic random-access memory (SDRAM), double data rate DRAM or DDR DRAM, flash memory, read only memory (ROM), programmable read only memory (PROM), electronically programmable read only memory (EPROM), electronically erasable and programmable read only memory (EEPROM), phase-change random-access memory (Phase-change RAM), ferroelectric random-access memory (FRAM), and resistive random-access memory (RRAM), or any other suitable memory devices, either alone or in combination. In the example embodiment of FIG. 1, the one or more memory cells 103 may be substantially similar to each other, while in other embodiments, the one or more memory cells 103 may differ from each other.

In the first device architecture 100, the addressing of individual elements such as capacitors, memory cells, or other suitable elements, may be done by use of one or more vertical electrodes 112 and one or more horizontal electrodes 116 to provide signals to one or more capacitors 105. In the example embodiment of FIG. 1, the one or more vertical electrodes 112 extend parallel to the Z-direction, while the one or more horizontal electrodes 116 extend orthogonal to the cross-section, and one or more capacitors 105 extend substantially to the X-direction. In some embodiments, each vertical electrode 112 may be used as a bit line and each horizontal electrode 116 may be used as a word line. In other embodiments, each one of the one or more vertical electrodes 112 may be used as the word line and each of the one or more horizontal electrode 116 may be used as a bit line. As used herein, terms such as bit line, word line, read line, address line, grid, array, and matrix may be used interchangeably to describe the various electrodes organized to provide a signal where two lines intersect within a larger device.

The one or more capacitors 105 may be connected to one or more transistors 118, to form one or more memory cells 103. In some embodiments, the one or more horizontal electrodes 116 may be coupled with one or more transistors 118 prior to the one or more capacitors 105. The one or more transistors 118 may take the form of a transistor such as a field effect transistor or FET, where a gate current may be applied by the horizontal electrode 116 to produce an effect to allow or prevent current flow within a semiconductor channel 110. The semiconductor channel 110 may be formed from a semiconductor material such as silicon or germanium, which may have its conductivity altered by the application of gate current.

As shown in FIG. 1, and discussed below in more detail, the one or more capacitors 105 each may include a bottom electrode 102, a top electrode 106, and an intermediate dielectric 104. Although referred to as the bottom electrode 102 and the top electrode 106, the actual orientation with respect to the individual electrodes may vary. In some embodiments, the bottom electrode 102 may be coupled to the one or more transistors 118, the one or more horizontal electrodes 116, and the one or more vertical electrodes 112, with the bottom electrode 102 receiving an electrical charge via an addressing matrix formed by the one or more vertical electrodes 112 and the one or more horizontal electrodes 116. The top electrode 106 may, in some embodiments, contact a plate conductor 114 which may, in some embodiments, act as the drain for the one or more capacitors 105. In some embodiments, the bottom electrode 102 thus may be referred to as the source-side electrode and the top electrode 106 may be referred to as the drain side electrode. The plate conductor 114 may be formed from any suitable conductor, such as metals, metal alloys, and metal nitrides or metal oxides, including titanium, titanium nitride, tungsten, tungsten nitride, and combinations thereof. In some embodiments, the conductive material of the plate conductor 114 may be formed by a semiconductor process such as chemical vapor deposition (CVD), atomic layer deposition (ALD), physical vapor deposition (PVD), electroplating, or any other suitable method for forming a conductive material. In some embodiments the plate conductor 114 may be formed of more than one layer, for example a liner layer or a glue layer prior to a bulk layer, as well as a contact. Such a listing of elements is not intended to be exhaustive, and in other embodiments, any known other type of conductive material may be used.

Although referred to as the drain side and the source side, in some embodiments, bottom electrode 102 may act as the drain, and the top electrode 106 may act as the source. The bottom electrode 102 and the top electrode 106 may be made of a suitable conductive material for use in semiconductor processing, for example a semiconductor material such as a conductive silicon material like doped silicon, as well as metals, or any other suitable conductor, alone or in combination. In some embodiments, the bottom electrode 102 and the top electrode 106 may be made of substantially the same material, while in other embodiments the bottom electrode 102 and the top electrode 106 may be made of different materials.

The intermediate dielectric 104 may separate the bottom electrode 102 and the top electrode 106 and, based on the dielectric constant and thickness of the dielectric material of the intermediate dielectric 104, may determine the amount of charge each of the one or more capacitors 105 may store. In some embodiments, the intermediate dielectric 104 may include semiconductor materials, as well as nitrides, carbides, and oxides thereof, and may include silicon nitride, silicon dioxide, or other similar materials such as gallium nitride, gallium oxide, and so forth. In some embodiments, the intermediate dielectric 104 may include a high-k dielectric with a higher dielectric constant (κ) than silicon dioxide, and may include materials such as oxides, silicides and silicates of hafnium and zirconium, such as hafnium silicate, zirconium silicate, hafnium dioxide and zirconium dioxide.

In the example embodiment of FIG. 1 and shown as well in the perspective view example of FIG. 2, the one or more capacitors 105 may be shaped in a nested form, where the top electrode 106 surrounds the bottom electrode 102, forming a solid shape. The one or more capacitors 105 may take the form of a cylinder, or any other suitable solid shape and include other shapes such as rectangular prisms, ovoids, tori, and other such shapes that may increase the surface area of the solid shape. In some embodiments, each of the one or more capacitors 105 may be regularly spaced apart from each other, with a pitch of 10-200 nm between each unit of the one or more capacitors 105, although in some embodiments, the pitch may be larger or smaller as desirable. The bottom electrode 102 may take the form of a first open cylinder, extending to form a U-shape in the cross-section. The top electrode 106 may form a complementary shaped second open cylinder surrounding the bottom electrode 102 and having W-shape in the cross-section. Thus, the top electrode 106 may have a central prong 107 which may be surrounded by the intermediate dielectric 104 and the bottom electrode 102. As such, the one or more capacitors 105 may effectively have the top electrode 106 surrounding the bottom electrode 102, while the central prong 107 of the top electrode 106 is surrounded by the bottom electrode 102 which forms an axial opening to receive the central prong 107. The outer portions of the top electrode 106 and the central prong 107 may thus both be capacitively coupled to the bottom electrode 102. As capacitance is proportional to surface area, the surface area of the central prong 107 and the outer portions of the top electrode 106 both may contribute to the capacitance between the top electrode 106 and the bottom electrode 102. As such the central prong 107 extending between the opposed surfaces of the bottom electrode 102 and the outer portions of the top electrode 106 together may provide a capacitance greater than either alone may provide. The central prong 107 may form the central axis for the top electrode 106 and the bottom electrode 102, with the top electrode 106 forming a cylinder arranged concentrically around the corresponding cylinder for the bottom electrode 102.

As shown in FIG. 1, a number of different materials may be used to provide isolation and support, including a first dielectric material 122, a second dielectric material 124, a liner or a protective or isolating layer 120 and a lining dielectric 128. In some embodiments, the dielectric material used to form the first dielectric material 122 and the second dielectric material 124 may include semiconductor materials, as well as nitrides, carbides, and oxides thereof. In some embodiments, the first dielectric material 122 and the second dielectric material 124 may include silicon nitride (Si₃N₄) or silicon dioxide (SiO₂), or other similar materials such as gallium nitride, gallium oxide, and so forth. In some embodiments, the first dielectric material 122 and the second dielectric material 124 may include the same dielectric material, while in other embodiments, the first dielectric material 122 and the second dielectric material 124 may include different materials. The isolating layer 120 may correspond to a dielectric material such as used in either of the first dielectric material 122 and the second dielectric material 124. Additionally, a transistor liner 126 may be formed between the semiconductor channel 110 and the horizontal electrode 116, as well as separate at least a portion of the first dielectric material 122 and the second dielectric material 124 from the semiconductor channel 110. The transistor liner 126 may be formed of a dielectric material, such as either of the first dielectric material 122 and the second dielectric material 124. The lining dielectric 128 may correspond to a dielectric material such as used in either of the first dielectric material 122 and the second dielectric material 124.

Segments of the isolating layer 120 may be formed between each of the one or more memory cells 103, with the isolating layer 120 contacting the bottom electrode 102 and portions of the intermediate dielectric 104. The isolating layer 120 may provide for isolation between adjacent units of the one or more capacitors 105, providing electrical, physical, and thermal isolation between adjacent units of the one or more capacitors 105, and thus prevent shorts between the one or more capacitors 105.

The first dielectric material 122 and the second dielectric material 124 may provide for electric protection between each of the one or more memory cells 103, with the first dielectric material 122 and the second dielectric material 124 providing electrical protection to prevent electrical shorting between each of the semiconductor channel 110, as well as the one or more horizontal electrodes 116. Furthermore, as discussed below, the first dielectric material 122 and the second dielectric material 124 may provide a back stop for recesses such as etching.

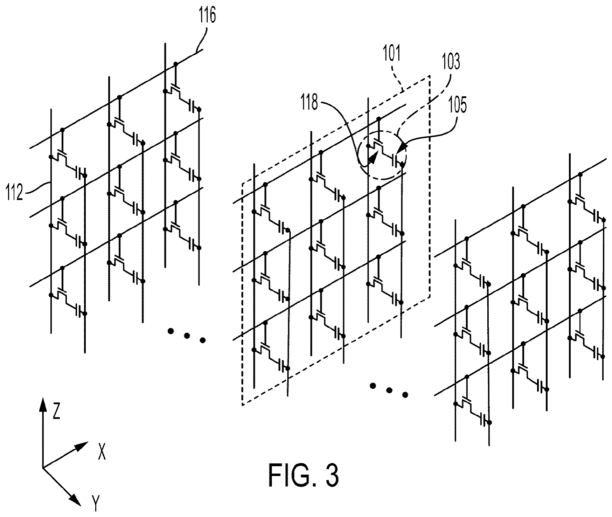

FIG. 3 provides a 3D circuit view of the first device architecture 100, a cell array of a semiconductor device according to example embodiments. The first device architecture 100 may include a plurality of sub-cell arrays 101, each of the plurality of sub-cell arrays 101 including one of the one memory cells 103. The plurality of sub-cell arrays 101 may be arranged in the Y-direction. Each of the plurality of sub-cell arrays 101 may include a plurality of bit lines, which may take the form of the vertical electrode 112, a plurality of word lines, which may take the form of the one or more horizontal electrodes 116 and the one or more memory cells 103. The one or more memory cells 103 may include a transistor 118 and a data storage element in the form of one or more capacitors 105. A single memory cell may be disposed between one of the one or more horizontal electrodes 116 and one of the vertical electrodes 112. As the top electrode 106 may act as the drain for the one or more capacitors 105, the top electrode 106 contacting multiple units of the one or more capacitors 105 may provide for a consistent bias to the capacitive structure.

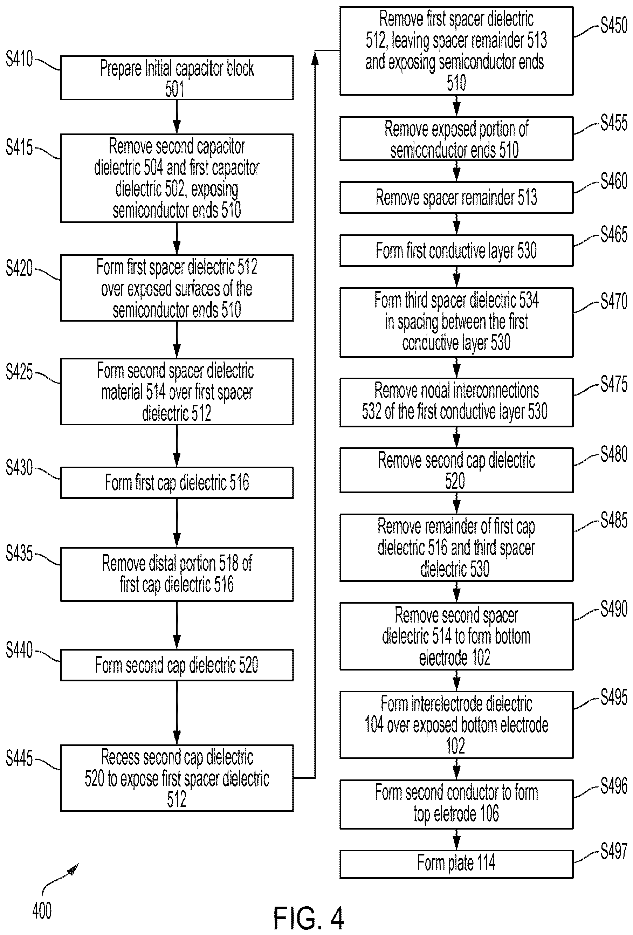

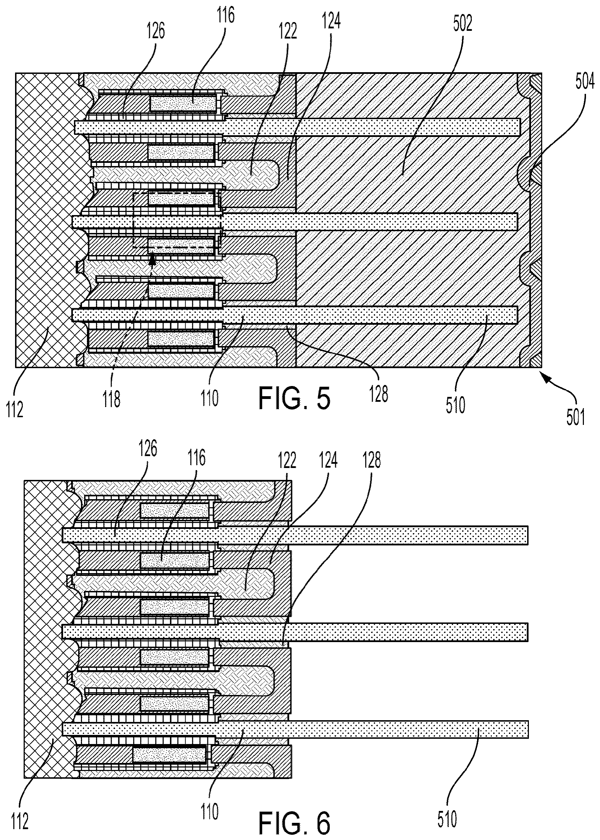

FIGS. 5-24 depict an illustrative embodiment of a process of forming a device architecture such as the first device architecture 100, or any other device architecture shown herein. FIG. 4 depicts a flowchart of an example embodiment of a process 400 for forming a device architecture corresponding to the illustrative embodiment of FIGS. 5-24.

FIG. 5 depicts S410 in the process of FIG. 4, where portions of the first device architecture 100 are prepared as the initial capacitor block 501. In the area where the one or more capacitors 105 are to be formed, portions of the first dielectric material 122, the second dielectric material 124 and the lining dielectric 128 can be found along with the semiconductor channel 110, one or more vertical electrodes 112, the one or more horizontal electrodes 116, forming one or more transistors 118. The initial capacitor block 501 may be formed by a series of process steps to form the initial structure containing the one or more transistors 118, and may use a number of techniques including deposition, diffusion, etching, lithography, and may be performed within a fabrication environment.

As shown in the example of FIG. 5, the first dielectric material 122 and the second dielectric material 124 may be formed in units between each transistor, with semiconductor channel 110 separating each unit vertically. The materials chosen for the first dielectric material 122 and the second dielectric material 124 may be chosen, at least in part, to allow for selective removal of one of the dielectric materials without substantially affecting the other dielectric material. For example, dielectrics formed using carbides, nitrides, and oxides may respond differently to different etch processes, including both wet-etch and dry-etch processes. The semiconductor channel 110 may be similarly chosen from a semiconductor material allowing selective removal from the first dielectric material 122 and the second dielectric material 124. In some embodiments, the first dielectric material 122 may take the form of silicon oxide, while the second dielectric material 124 may take the form of silicon nitride, and the semiconductor channel 110 may take the form of silicon.

In the initial capacitor block 501, the semiconductor channel 110 may extend beyond the first dielectric material 122 and the second dielectric material 124, with semiconductor ends 510 of the semiconductor channel 110, surrounded by a first capacitor dielectric 502, with a second capacitor dielectric 504 forming an end cap. The first capacitor dielectric 502 may be formed of a dielectric material such as the first dielectric material 122, and the second capacitor dielectric 504 may be formed of a different dielectric material such as the second dielectric material 124. The first capacitor dielectric 502 may extend between the second dielectric material 124 and the second capacitor dielectric 504, surrounding on all sides the semiconductor ends 510 of the semiconductor channel 110. The lining dielectric 128 may, in some embodiments, be a portion of the first capacitor dielectric 502 extending between the semiconductor channel 110 and the second dielectric material 124.

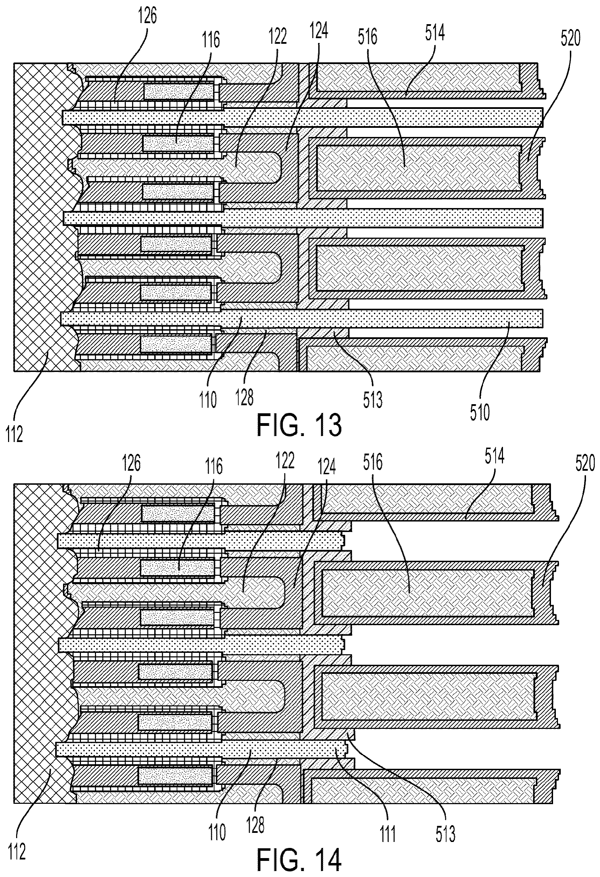

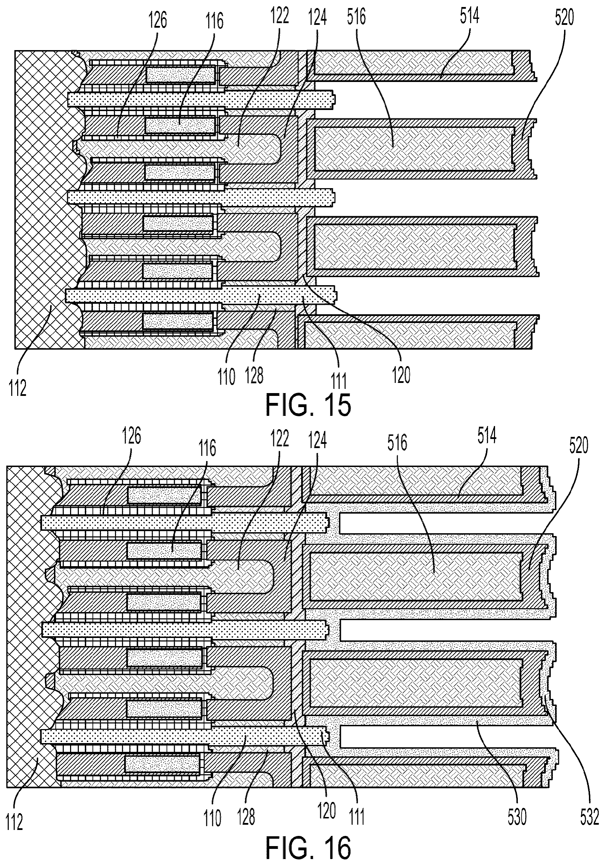

FIG. 6 depicts S415 in the process of FIG. 4, where both the first capacitor dielectric 502 and the second capacitor dielectric 504 may be removed, exposing the semiconductor ends 510 of the semiconductor channel 110. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The lining dielectric 128 may, in some embodiments, be a portion of the first capacitor dielectric 502 extending between the semiconductor channel 110 and the second dielectric material 124. This step may be referred to as oxide recess. As will be shown in FIGS. 14 and 15, a semiconductor end 510 of the semiconductor channel 110, or silicon, may be recessed. By performing oxide recess prior to silicon recess, the amount of silicon recess may be accurately controlled, leading to a uniform silicon channel length throughout the capacitors 105.

In some embodiments, an initial removal step may be used to remove the second capacitor dielectric 504 fully prior to a second removal step to remove the first capacitor dielectric 502. While in other embodiments, a single removal process may be used for both the first capacitor dielectric 502 and the second capacitor dielectric 504. The materials chosen for the first capacitor dielectric 502 and the second capacitor dielectric 504 may be such that a selective removal process may produce a noticeably different response for each material, as such, a different removal process may be used for each of the first capacitor dielectric 502 and the second capacitor dielectric 504. With a different removal response rate, the second dielectric material 124 may act as a self-aligned etch stop, such that a removal process which fully removes the first capacitor dielectric 502 may stop at the second dielectric material 124. As such, the second dielectric material 124 may provide a consistent exposure of the semiconductor ends 510 of the semiconductor channel 110 and may allow for the one or more capacitors 105 to have a consistent size. As a result, the lengths of the semiconductor channel 110 in the resulting capacitors 105 are constant or approximately equal to the same length.

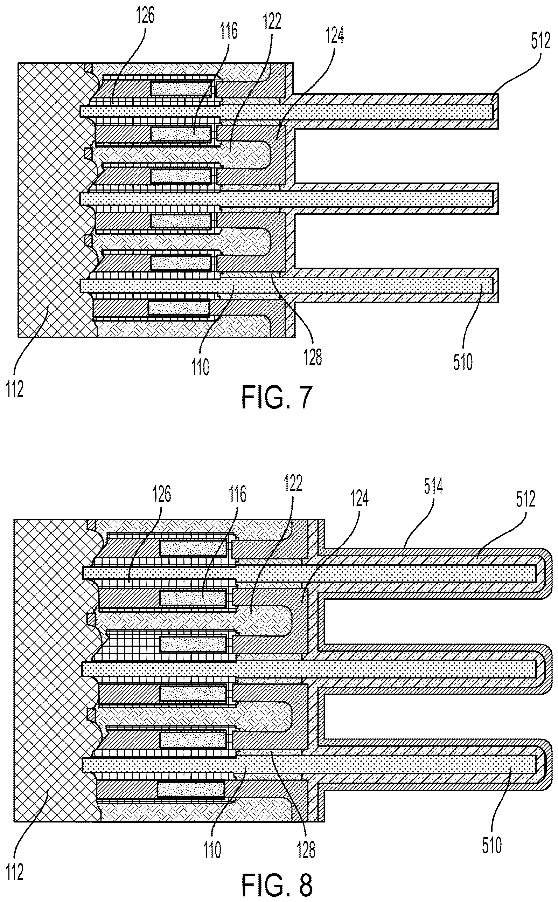

FIG. 7 depicts S420 in the process of FIG. 4, where a first spacer dielectric 512 may be formed over the exposed surfaces of the semiconductor ends 510 of the semiconductor channel 110. The first spacer dielectric 512 may be formed of a material similar to the first dielectric material 122, such as a nitride, oxide or carbide of a semiconductor material, and may be formed by any suitable process, such as chemical vapor deposition (CVD), atomic layer deposition (ALD), epitaxial growth, diffusion, or any other suitable method known in the art. The first spacer dielectric 512 may be formed using a conformal process to form a layer over the exposed portions of the semiconductor ends 510 of the semiconductor channel 110 as well as the second dielectric material 124 and the lining dielectric 128.

FIG. 8 depicts S425 in the process of FIG. 4, where a second spacer dielectric 514 may be formed over the first spacer dielectric 512. The second spacer dielectric 514 may be formed of a material similar to the second dielectric material 124, such as a nitride, oxide or carbide of a semiconductor material, and may be formed by any suitable process, such as CVD, ALD, epitaxial growth, diffusion, or any other suitable method known in the art. The second spacer dielectric 514 may be formed using a conformal process to form a layer over the first spacer dielectric 512. The second spacer dielectric 514 may be formed of a different dielectric material than the first spacer dielectric 512 and may be chosen to have a different response to removal, for example an etchant.

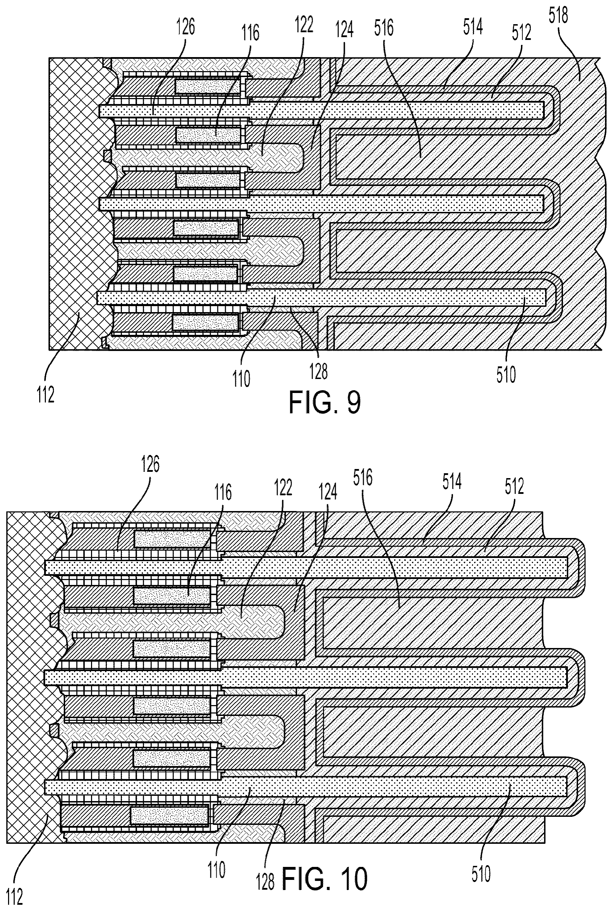

FIG. 9 depicts S430 in the process of FIG. 4, where a first cap dielectric 516 may be formed. The first cap dielectric 516 may be formed of a material similar to the first dielectric material 122, such as a nitride, oxide or carbide of a semiconductor material, and may be formed by any suitable process, such as CVD, ALD, epitaxial growth, diffusion, or any other suitable method known in the art. The first cap dielectric 516 may be formed so as to fill in any remaining space between each of the semiconductor ends 510 of the semiconductor channel 110 and may extend outwards from the end of each of the semiconductor ends 510 of the semiconductor channel 110. The first cap dielectric 516 has a distal portion 518.

FIG. 10 depicts S435 in the process of FIG. 4, where a distal portion 518 of the first cap dielectric 516 may be removed. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The removal may expose a portion of the second spacer dielectric 514 at a distal portion of the semiconductor ends 510 of the semiconductor channel 110.

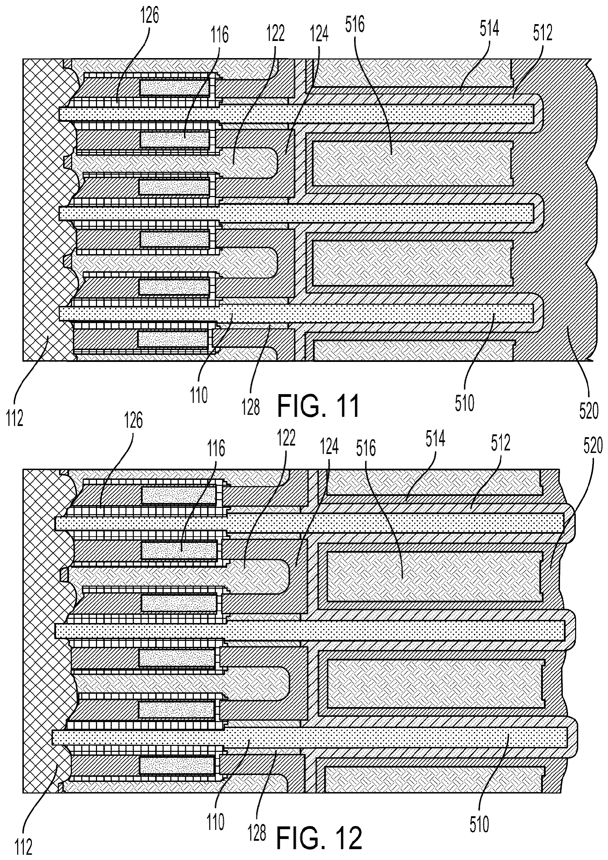

FIG. 11 depicts S440 in the process of FIG. 4, where a second cap dielectric 520 may be formed. The second cap dielectric 520 may be formed of a material similar to the second dielectric material 124, such as a nitride, oxide or carbide of a semiconductor material, and may be formed by any suitable process, such as CVD, ALD, epitaxial growth, diffusion, or any other suitable method known in the art. The second cap dielectric 520 may be formed of a different dielectric material than the first cap dielectric 516 and may be chosen to have a different response to removal, for example an etchant. The second cap dielectric 520 may extend outward from a distal portion of the semiconductor ends 510 of the semiconductor channel 110.

FIG. 12 depicts S445 in the process of FIG. 4, where the second cap dielectric 520 may be recessed to expose the first spacer dielectric 512. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The removal may expose a portion of the first spacer dielectric 512 at a distal portion of the semiconductor ends 510 of the semiconductor channel 110. The second spacer dielectric 514 and the remaining portion of the second cap dielectric 520 may form a single structure surrounding the first cap dielectric 516.

FIG. 13 depicts S450 in the process of FIG. 4, where the first spacer dielectric 512 may be partially removed, and may leave a spacer remainder 513 and expose at least a portion of the semiconductor ends 510 of the semiconductor channel 110. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The removal may expose the semiconductor ends 510 of the semiconductor channel 110 as well as portions of the second spacer dielectric 514. A portion of the first spacer dielectric 512, referred to as the spacer remainder 513, may remain between the semiconductor channel 110 and the second spacer dielectric 514.

FIG. 14 depicts S455 in the process of FIG. 4, where the semiconductor ends 510 of the semiconductor channel 110 may be removed. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process, and may be performed using a lateral selective etch. The removal may expose a nub end 111 of the semiconductor channel 110. By recessing the first spacer dielectric 512 prior to the semiconductor ends 510 of the semiconductor channel 110, the second spacer dielectric 514 may protect the first cap dielectric 516 and may allow for the height and length of the one or more capacitors 105 to be as large as possible. Additionally, removing a portion of the first spacer dielectric 512 prior to removing the semiconductor ends 510 of the semiconductor channel 110 may provide for a more controlled removal of the semiconductor ends 510 of the semiconductor channel 110. The spacer remainder 513 may act as an etch stop or a barrier for a removal process to prevent excess removal and allow the nub end 111 of the semiconductor channel 110 to remain extending outwards from the second dielectric material 124 and may provide for a better contact with less resistance between the semiconductor channel 110 to the bottom electrode 102.

FIG. 15 depicts S460 in the process of FIG. 4, where the spacer remainder 513 may be removed. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. A portion of the spacer remainder 513, and thus the first spacer dielectric 512, may remain between the second dielectric material 124 and the second spacer dielectric 514. The remaining portion may form the isolating layer 120.

FIG. 16 depicts S465 in the process of FIG. 4, where a first conductive layer 530 may be formed. By removing the first spacer dielectric 512 around the nub end 111 of the semiconductor channel 110, a contact area may be formed to provide a suitable contact between the semiconductor channel 110 and the first conductive layer 530. The first conductive layer 530 may be a conductive material, which may include doped semiconductor materials, metals such as tungsten, functionalized carbon nanomaterials, as well as any other suitable conductive material. In some embodiments, the first conductive layer 530 may be formed by a semiconductor process such as physical vapor deposition (PVD), as well as CVD, ALD, electroplating, or any other suitable method for forming a conductive material. In some embodiments, the first conductive layer 530 may be formed by a conformal process to coat the exposed surfaces, including portions of the semiconductor channel 110, the isolating layer 120, and the second spacer dielectric 514. The thickness of the first conductive layer 530 may be between 5-10 nm, although in some embodiments, the thickness may be larger or smaller, for example between 1-105 nm in thickness. The portions of the first conductive layer 530 covering the distal ends of the second cap dielectric 520 may be referred to as the nodal interconnects 532. The nodal interconnections 532 may be removed in subsequent steps to separate the first conductive layer 530 and form the bottom electrode 102 for the one or more capacitors 105.

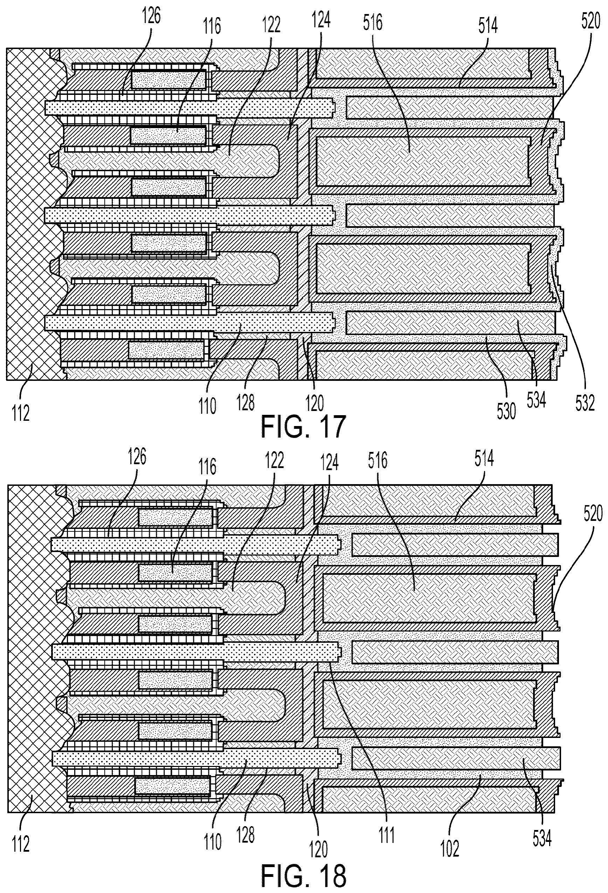

FIG. 17 depicts S470 in the process of FIG. 4, where a third cap dielectric 534 may be formed in the spacing between segments of the first conductive layer 530. The third cap dielectric 534 may be formed of a material similar to the first dielectric material 122, such as a nitride, oxide or carbide of a semiconductor material, and may be formed by any suitable process, such as CVD, ALD, epitaxial growth, diffusion, or any other suitable method known in the art. The third cap dielectric 534 may be formed of a different dielectric material than the second cap dielectric 520 and may be chosen to have a different response to removal methods, for example having a different etch response. The third cap dielectric 534 may be formed of the same material as the first cap dielectric 516, and may be chosen to have a similar response to removal methods, for example having a similar etch response.

FIG. 18 depicts S475 in the process of FIG. 4, where nodal interconnects 532 of the first conductive layer 530 may be removed so that the first conductive layer 530 without the nodal interconnects 532 may form the bottom electrode 102 and may create individual capacitor structures for the one or more capacitors 105. The nodal interconnects 532 may be removed using any suitable semiconductor process, and may include techniques such as etching, including both wet-etch processes using chemicals and dry-etch processes using reactive plasma, as well as lithography, mechanical drilling or cutting, lasers, and a combination of these methods and any other suitable methods known in the art. In some embodiments, the process may be a selective etch process and may be performed using a lateral selective etch. The removal of portions of the first conductive layer 530 may create a small recess between the second cap dielectric 520 and the third cap dielectric 534, with the third cap dielectric 534 exposed by the removal.

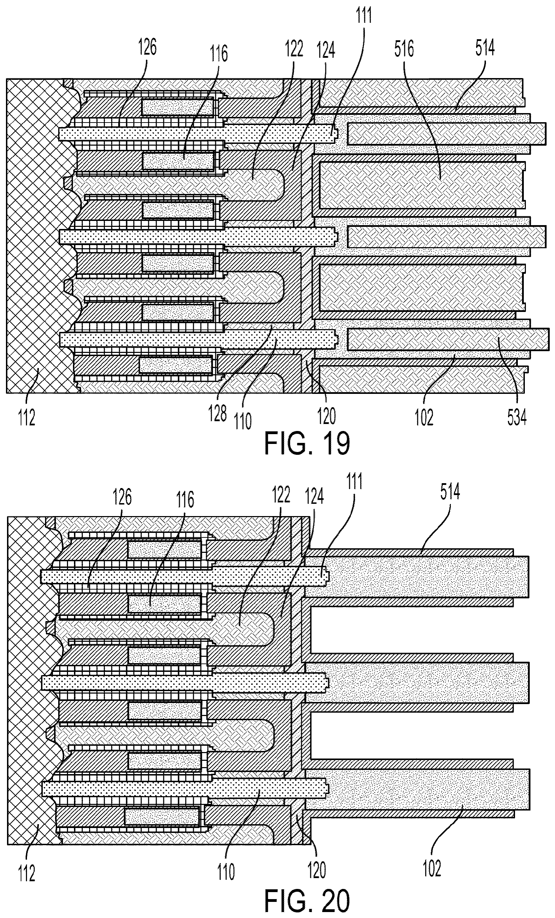

FIG. 19 depicts S480 in the process of FIG. 4, where remaining portions of the second cap dielectric 520 may be removed. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The removal of the second cap dielectric 520 may remove a portion of the second spacer dielectric 514, between the first cap dielectric 516 and the third cap dielectric 534.

FIG. 20 depicts S485 in the process of FIG. 4, where a remainder of the first cap dielectric 516 and the third cap dielectric 534 may be removed. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The first cap dielectric 516 and the third cap dielectric 534 may be formed of the same material as the first dielectric material 122, such that the first cap dielectric 516 and the third cap dielectric 534 may be selectively removed while the first conductive layer 530 (or the bottom electrode 102) and the second spacer dielectric 514 remain.

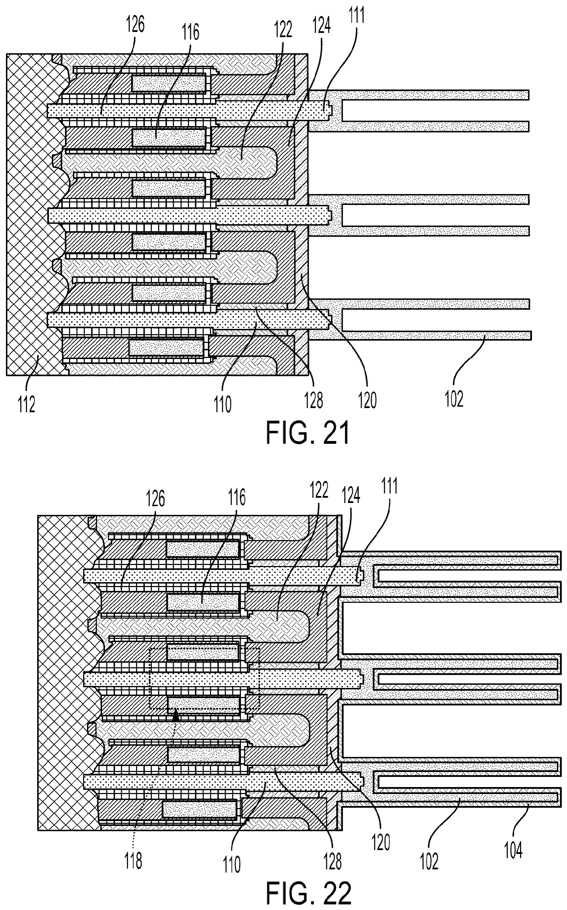

FIG. 21 depicts S490 in the process of FIG. 4, where the second spacer dielectric 514 may be removed to reveal or expose the bottom electrode 102. The removal may be performed by one or more etch processes, such as wet-etch processes using chemicals and dry-etch processes using reactive plasma, as well as any other suitable method of removal. In some embodiments, an etching step may be used in combination with a masking step, such as a photoresist mask formed using a lithographic process to selectively cover portions of the first device architecture 100, as well as any other suitable method for patterning, such as use of lasers, mechanical drilling, etc. In some embodiments, the process may be a selective etch process and may be performed using a lateral selective etch. The material of the second spacer dielectric 514 may be chosen such that selective removal of the second spacer dielectric 514 may leave the first conductive layer 530 and the isolating layer 120 in place.

FIG. 22 depicts S495 in the process of FIG. 4, where the intermediate dielectric 104 may be formed over the bottom electrode 102. The intermediate dielectric 104 may be formed by any suitable process, such as CVD, ALD, epitaxial growth, diffusion, or any other suitable method known in the art to form a dielectric material. The intermediate dielectric 104 may consist of a high-k dielectric with a higher dielectric constant (κ) than silicon dioxide, and may include materials such as oxides, silicides and silicates of hafnium and zirconium, such as hafnium silicate, zirconium silicate, hafnium dioxide and zirconium dioxide. In some embodiments, the intermediate dielectric 104 may be formed to have a conformal coating over the bottom electrode 102 and the isolating layer 120, and may be formed to a thickness in the range of 5-10 nm, although in some embodiments, the thickness may be larger or smaller, for example between 1-105 nm in thickness.

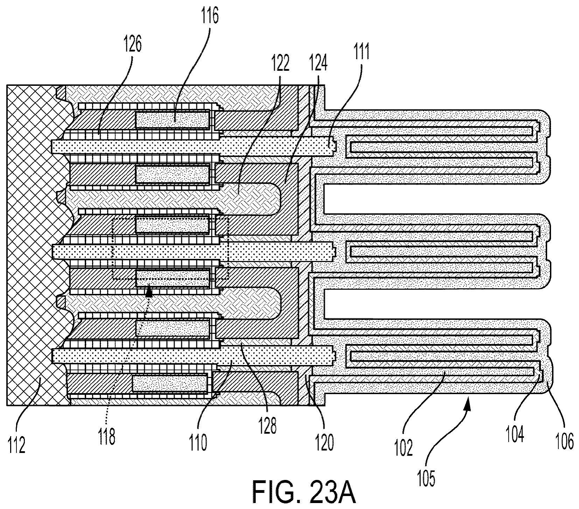

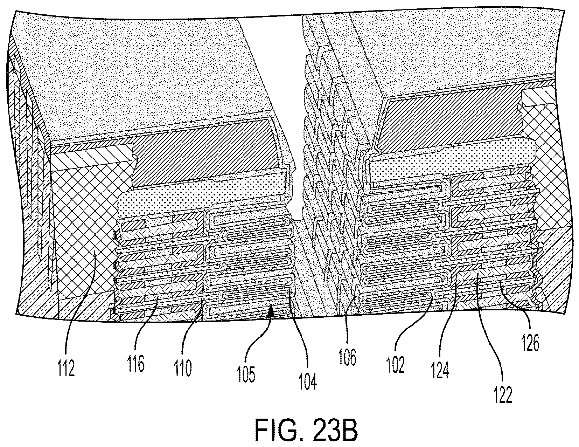

FIG. 23A and FIG. 23B depicts S496 in the process of FIG. 4, where a second conductor is formed over the intermediate dielectric 104 to form the top electrode 106. FIG. 23A provides a cross-sectional view, while FIG. 23B provides a perspective view of the first device architecture 100. The top electrode 106 may be formed of a conductive material, which may include doped semiconductor materials, metals such as tungsten, functionalized carbon nanomaterials, as well as any other suitable conductive material. In some embodiments, the conductive material of the top electrode 106 may be formed by a semiconductor process such as CVD, ALD, PVD) electroplating, or any other suitable method for forming a conductive material. In some embodiments, the top electrode 106 may be formed by a conformal process to coat the exposed surfaces of the intermediate dielectric 104. The thickness of the top electrode 106 may be between 5-10 nm, although in some embodiments, the thickness may be larger or smaller, for example between 1-105 nm in thickness.

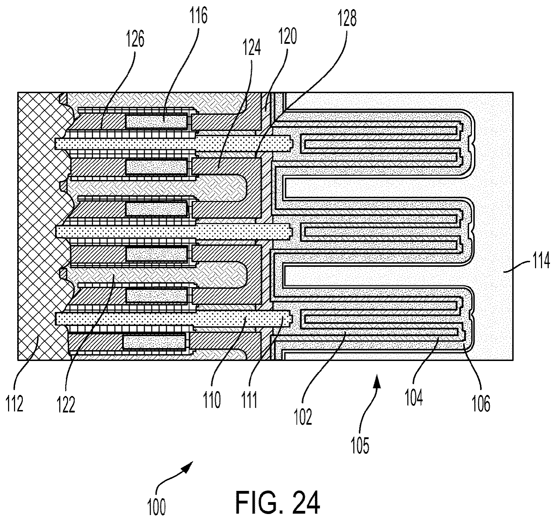

FIG. 24 depicts S497 in the process of FIG. 4, where the plate conductor 114 may be formed between segments of the one or more capacitors 105. The plate conductor 114 may be formed from a conductive material, which may include metals such as tungsten, aluminum, titanium, as well as any other suitable conductive material. In some embodiments, the conductive material of the plate conductor 114 may be formed by a semiconductor process such as CVD, ALD, PVD, electroplating, or any other suitable method for forming a conductive material. In some embodiments, the plate conductor 114 may be formed of multiple layers, while in other embodiments, a single layer may be formed. In some embodiments, the plate conductor 114 may be chosen for suitability to contact the material forming the top electrode 106, while a second plate conductor may form the drain line for the first device architecture 100. In some embodiments the plate conductor 114 may include one or more additional layers to form a liner layer or glue layer. In some embodiments, the plate conductor 114 may be referred to as a plug, conductive plug, plug metal, or plate conductive layer.

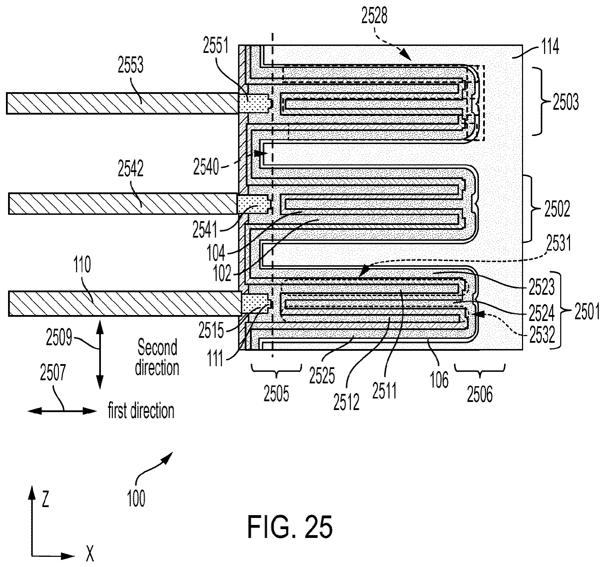

FIG. 25 is a diagram of an example embodiment depicting the first device architecture 100 including parts of three capacitors a first capacitor 2501, a second capacitor 2502, and a third capacitor 2503 according to one embodiment. For clarity, not all components are shown. The three capacitors may have similar structures as the capacitor 105 shown in FIG. 1. The first capacitor 2501, the second capacitor 2502, and the third capacitor 2503 are joined together to form a contiguous connection and may share a common ground. The intermediate dielectric 104 may form a contiguous and continuous layer between all three capacitors.

The first device architecture 100 includes the first capacitor 2501, a semiconductor channel 110, and the intermediate dielectric 104.

The first capacitor 2501 may be similar to the capacitor 105 shown in FIG. 1. The first capacitor 2501 may include a first or bottom electrode 102 and a second or top electrode 106. The bottom electrode 102 may have a proximal end 2505 and a distal end 2506. The bottom electrode 102 may include a first segment 2511 and a second segment 2512 extending from the proximal end 2505 to the distal end 2506 in a first direction 2507 and joined at the proximal end 2505 by a connecting segment to form a mouth 2515. The first direction 2507 may be the X-direction. The mouth 2515 may extend as a contact point between the bottom electrode 102 and the semiconductor channel 110. In one embodiment, the first direction 2507 is horizontal. The top electrode 106 may include a third segment 2523, a fourth segment 2524, and a fifth segment 2525 which may be joined together to form a fork 2528 (shown in a separate capacitor to improve clarity) facing the bottom electrode 102 in the first direction 2507. The fork 2528 may have a first slot 2531 and a second slot 2532. The first slot 2531 may cover or enclose the first segment 2511 of the bottom electrode 102 between the third segment 2523 and the fourth segment 2524. The second slot 2532 may cover or enclose the second segment 2512 of the bottom electrode 102 between the fourth segment 2524 and the fifth segment 2525. The bottom electrode 102 may have a first open cylinder shape extending to form a U-shape cross-section. The top electrode 106 may have a second open cylinder shape and a W-shape cross section. With these complementary cylindrical shapes, the bottom electrode 102 and the top electrode 106 may together form a cylindrical shape. This may increase the surface area of the electrodes and therefore increase the capacitance of the capacitor, which in turn increases the memory density of the associated memory cells. The cylindrical shapes may share the same axis and thus may be coaxially arranged.

The semiconductor channel 110 may be arranged, disposed, or positioned on a side of the bottom electrode 102 opposite the top electrode 106. The semiconductor channel 110 may have a nub end 111 and may extend in the first direction 2507 fittingly into the mouth 2515 of the bottom electrode 102 at the proximal end 2505. The connection between the semiconductor channel 110 and the bottom electrode 102 at the mouth 2515 may provide an electrical connection between the two parts.

The second capacitor 2502 and the third capacitor 2503 may be similar to the first capacitor 2501 and therefore their description is omitted. The second capacitor 2502 may be mechanically and electrically connected to a second semiconductor channel 2542. Similarly, the third capacitor 2503 may be mechanically and electrically connected to a third semiconductor channel 2553. The second semiconductor channel 2542 and third semiconductor channel 2553 may be similar to the semiconductor channel 110. The second semiconductor channel 2542 and third semiconductor channel 2553 may have second nub end 2541 and third nub end 2551, respectively. As shown in FIGS. 6, 14 and 15, the semiconductor channel 110, second semiconductor channel 2542 and third semiconductor channel 2553 may be formed as a silicon recess after the oxide recess in FIG. 6. This step may lead to accurate control of the length of the semiconductor channels. Accordingly, the nub end 111 and second nub end 2541 may be aligned in a second direction 2509 orthogonal to the first direction 2507. The second direction 2509 may be the Z-direction. The nub end 111, second nub end 2541 and third nub end 2551 may be aligned on a depth line 2540 in the second direction 2509 orthogonal to the first direction 2507.

While this specification may contain many specific implementation details, the implementation details should not be construed as limitations on the scope of any claimed subject matter but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific example teachings discussed above, but is instead defined by the following claims.

## Claims

1. A device comprising:
a first capacitor comprising:
a first electrode having a first segment and a second segment extending from a proximal end to a distal end in a first direction and joined at the proximal end by a connecting segment to form a mouth;
a second electrode having a third segment, a fourth segment, and a fifth segment joining together to form a fork facing the first electrode in the first direction, the fork having a first slot enclosing the first segment between the third segment and the fourth segment and a second slot enclosing the second segment between fourth segment and the fifth segment;
a first semiconductor channel arranged on a side of the first electrode opposite the second electrode, the first semiconductor channel having a first nub end and extending in the first direction into the mouth at the proximal end; and
an intermediate dielectric layer arranged between the first electrode and the second electrode and extending alongside the third segment, the fourth segment, and the fifth segment in the first slot and the second slot.

2. The device of claim 1, wherein the first electrode has a first open cylinder shape extending to form a U-shape cross-section, and the second electrode has a second open cylinder shape and the second electrode has a W-shape cross section.

3. The device of claim 1 or 2, further comprising:
a second semiconductor channel having a second nub end and extending in the first direction above the first semiconductor channel into a second capacitor having a structure similar to the first capacitor,
wherein the first nub end and the second nub end are aligned in a second direction, the second direction orthogonal to the first direction.

4. The device of any one of claims 1 to 3, wherein the intermediate dielectric layer comprises a material having a higher dielectric constant than silicon oxide.

5. The device of any one of claims 1 to 4, wherein
the intermediate dielectric layer conformally encloses the first electrode, and
the second electrode conformally encloses the intermediate dielectric layer.

6. The device of any one of claims 1 to 5, wherein the second electrode concentrically encloses the first electrode.

7. The device of any one of claims 1 to 6, wherein
the first electrode is coupled to a source,
the second electrode is coupled to a drain,
a transistor is between the first electrode and the source, and
the first electrode, the second electrode, and the transistor form a memory cell.

8. A method comprising:
forming a mold within a first dielectric;
depositing a first conductor within the mold, the first conductor conformally coating the mold;
forming the first conductor into one or more first electrodes;
forming an intermediate dielectric over the one or more first electrodes; and
depositing a second conductor over the intermediate dielectric to form one or more second electrodes,
wherein the one or more first electrodes are separated by the first dielectric, and wherein the one or more second electrodes form a continuous layer.

9. The method of claim 8, wherein
the first dielectric comprises one or more of a carbide, nitride, or oxide, and
the intermediate dielectric comprises a material having a higher dielectric constant than silicon oxide.

10. The method of claim 8 or 9, wherein
depositing the second conductor is performed by a conformal process, and
depositing the intermediate dielectric is performed by a conformal process.

11. The method of any one of claims 8 to 10, further comprising, after depositing the second conductor, depositing a plate conductor over the second conductor.

12. The method of any one of claims 8 to 11, wherein forming the first conductor into the one or more first electrodes includes removing portions of the first conductor between each of the one or more first electrodes.

13. The method of any one of claims 8 to 12, wherein forming the mold within the first dielectric is performed in a direction parallel to a planar surface of a substrate supporting the first dielectric.

14. The method of any one of claims 8 to 13, wherein the intermediate dielectric forms a contiguous layer between the one or more first electrodes and the one or more second electrodes.
